# EUROPEAN PATENT SPECIFICATION

(11) **EP 2 560 201 B1**
(45) Date of publication and mention of the grant of the patent: **02.10.2019**
(21) Application number: 11194105.0
(22) Date of filing: 16.12.2011
(51) Int. Cl.: H01L 23/36, H01L 23/367, H01L 23/538

(54) **Semiconductor packaging structure and method of fabricating the same**
Halbleiterverpackungsstruktur und Verfahren zu deren Herstellung
Structure de conditionnement de semi-conducteur et son procédé de fabrication

(30) Priority: 19.08.2011 TW 100129815
(43) Date of publication of application: 20.02.2013
(73) Proprietor: Unimicron Technology Corp., Taoyuan (TW)
(72) Inventor: Hu, Dyi-Chung, Taoyuan (TW); Hu, Yu-Shan, Taoyuan (TW)
(74) Representative: Becker Kurig Straus

(56) References cited:
- DE-A1- 10 324 615
- TW-A- 201 244 033
- US-A1- 2004 099 933
- US-A1- 2004 238 945
- US-A1- 2011 037 165
- US-A1- 2012 273 930

## Description

### BACKGROUND OF THE INVENTION

### 1. Field of the Invention

The present invention relates generally to semiconductor packaging structures and methods of fabricating the same, and, more particularly, to a semiconductor packaging structure embedded with semiconductor chips and a method of fabricating the same.

### 2. Description of Related Art

With the rapid development of electronics industry, electronic products are trending to being low-profiled and compact-sized, while still need to meet the Joint Electronic Device Engineering Council (referred to as JEDEC) specification, so how the electronic products are packaged is quite important. For example, owing to the chip of Dynamic Random Access Memory (referred to as DRAM) is developed to be manufactured under 40 nanometer (nm), the size of the chip is getting smaller and smaller, while the area of the packaging structure has to maintain the same for the solder ball pitch of the packaging structure for being attached to a circuit board (PCB)to be set at 0.8 mm, in order to meet the JEDEC standard. Accordingly, the Fan-out wafer level package (WLP) is one of the currently employed approaches to cope with the aforementioned demand. The Double-Data-Rate Three Synchronous Dynamic Random Access Memory (referred to as DDR3 SDRAM) is the latest computer memory specification, which is fabricated as a window-type ball grid array package.

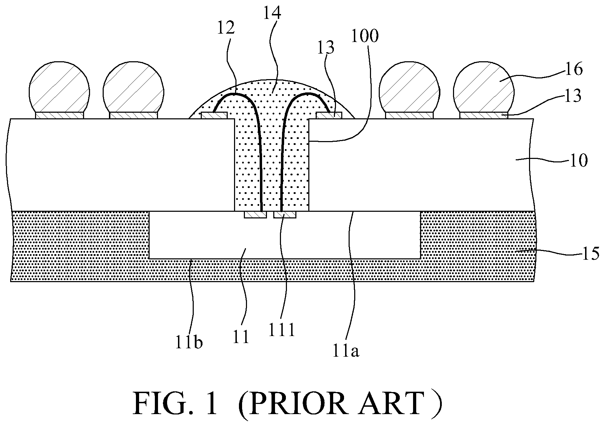

Referring to FIG. 1, a cross-sectional view illustrating a semiconductor packaging structure of a window-type ball grid array according to the prior art is provided. The semiconductor packaging structure includes a packaging substrate 10 and a semiconductor chip 11. The packaging substrate 10 has at least one through opening 100. The semiconductor chip 11 has an active surface 11a on which a plurality of electrode pads 111 are formed and an inactive surface 11b opposing the active surface 11a. The active surface 11a of the semiconductor chip 11 is attached to a first surface of the packaging substrate 10 and covers one end of the opening 100. A plurality of gold wires 12 pass through the opening 100. The electrode pads 111 are electrically connected to conductive pads 13 formed on a second surface of the packaging substrate 10. A first packaging material 14 is formed to encapsulate the gold wire 12 and a second packaging material 15 is formed on the packaging substrate 10 to encapsulate the semiconductor chip 11. Solder balls 16 are disposed on conductive pads 13 formed on the packaging substrate 10. The overall height (including the solder balls 16) of the semiconductor packaging structure is typically between 1.1 to 1.2 mm.

However, as the electrode pads 111 are electrically connected to the conductive pads 13 on the second surface of the packaging substrate 10 by the gold wires 12 passing through the opening 100, the gold wires 12 are length that affect the signal transmission efficiency. And, the gold is costly to use, such that the cost for fabricating the semiconductor packaging structure is increased. In addition, the semiconductor chip 11 is attached to one end of the opening 100, and the gold wires 12 and the semiconductor chip 11 are covered by the first packaging material 14 and the second packaging material 15, such that heat generated by the semiconductor chip 11 cannot be dissipated from the semiconductor packaging structure efficiently. Moreover, the semiconductor packaging structure is thick, which is adverse to be applied to portable electronic products.

Therefore, it is desirable to provide a semiconductor packaging structure and method of fabricating the same in order to avoid the poor heat dissipation of the semiconductor packaging structure of the conventional window-type ball grid array, the low efficiency of the electrical transmission, and the packaging thickness being too large, resulting in poor product reliability or limited range of applications of the prior art.

Document DE 103 24 615 A1 discloses an electronic component and a method as well as a device for manufacturing the electronic component. A heat conductive plate is arranged on the backside of the electronic component. Moreover, US 2004/0238945 A1 discloses a thermally enhanced semiconductor package and fabrication method thereof. An encapsulation body encapsulates a heat sink, chip and conductive bumps, while exposing a bottom or surface of the heat sink and ends of the conductive bumps outside.

### SUMMARY OF THE INVENTION

In view of the above drawbacks of the prior art, the present invention provides a semiconductor packaging structure and a method of fabricating the same.

To achieve the above-mentioned and other objectives, the present invention provides a semiconductor packaging structure, comprising: a semiconductor chip having an active surface and an inactive surface opposing the active surface; a plurality of electrode pads formed on the active surface; a plurality of metal bumps formed on the electrode pads; a packaging layer encapsulating the semiconductor chip and exposing the active surface; a dielectric layer formed on the active surface and a surface of the packaging layer at the same side with the active surface and having a plurality of wiring pattern openings for the metal bumps to be exposed therefrom; a wiring layer formed in the wiring pattern openings and electrically connected to the metal bumps, the wiring layer extending to the dielectric layer on the surface of the packaging layer formed at the same side with the active surface; an insulating protective layer formed on the dielectric layer and the wiring layer, and having a plurality of openings to expose a portion of the wiring layer; and a metallic foil disposed on the surface of the packaging layer at the same side with the inactive surface, a plurality of metallic protrusions being formed on the metallic foil and penetrating the packaging layer to be in contact with the inactive surface of the semiconductor chip, such that heat generated by the semiconductor chip is dissipated to an ambient environment, wherein the metallic protrusions are printed bumps or punched bumps, and wherein for the punched bumps, dimples are formed on an exposed surface of the metallic foil and conform with the metallic protrusions.

The present invention further provides a method of fabricating a semiconductor packaging structure, comprising: providing a carrier board; forming a first adhesive layer on the carrier board; wherein each of the semiconductor chips has an active surface and an inactive surface opposing the active surface, and a plurality of metal bumps are formed on a plurality of electrode pads formed on the active surface, attaching a plurality of semiconductor chips to the first adhesive layer formed on the carrier board, such that the semiconductor chips are mounted on the first adhesive layer via the metal bumps; forming a second adhesive layer on the first adhesive layer, allowing the inactive surface of the semiconductor chip to be exposed from the second adhesive layer; providing a metallic foil having a third adhesive layer formed on the metallic foil, wherein the metallic foil has a plurality of metallic protrusions exposed from the third adhesive layer; attaching the metallic foil covered with the third adhesive layer to the second adhesive layer in a manner that the third adhesive layer is interposed between the metallic foil and second adhesive layer, thereby allowing a plurality of metallic protrusions formed on the metallic foil and penetrating the third adhesive layer to be in contact with the inactive surface of each of the
semiconductor chips, and allowing the second adhesive layer and the third adhesive layer to form a packaging layer; removing the carrier board and the first adhesive layer; forming a dielectric layer on the second adhesive layer and the semiconductor chips, the dielectric layer having a plurality of wiring pattern openings for exposing the metal bumps; forming a wiring layer in the wiring pattern openings for the wiring layer to be electrically connected to the metal bumps; forming an insulating protective layer on the dielectric layer and the wiring layer, the insulating protective layer having a plurality of insulating protective layer openings for exposing a portion of the wiring layer; removing a portion of the metallic foil to form a plurality of metallic foil grooves, such that the metallic foil on each of the semiconductor chips are allowed to be free from connecting with each other; and cutting the second adhesive layer, the third adhesive layer, the dielectric
layer and the insulating protective layer along the metallic foil grooves, so as to form a plurality of semiconductor packaging structures.

From the foregoing, with the employment of the dielectric layer in the semiconductor packaging structure of the present invention, conventional gold wires as the electrical conduction path and costly packaging substrates as chip carrier are free from being used and thus the overall thickness of the semiconductor packaging structure of the present invention is effectively reduced. Furthermore, the present invention has the inactive surfaces of the semiconductor chips connected with the metallic protrusions, such that the heat generated by the semiconductor chip can be transferred directly to the metallic foil with large area for heat dissipation. As a result, the heat dissipation efficiency of the semiconductor packaging structure of the present invention is enhanced. Finally, the present invention requires no gold wires with a longer conduction path to transmit electrical signals, such that better electrical transmission efficiency can be achieved, thereby enhancing the reliability of the final product while also reducing the material costs for gold wires.

### BRIEF DESCRIPTION OF DRAWINGS

FIG. 1 is cross-sectional view illustrating a semiconductor packaging structure of the window-type ball grid array according to the prior art;
FIGs. 2A to 2C are cross-sectional views illustrating semiconductor chips of a semiconductor packaging structure and a method of fabricating the same according to the present invention;
FIGs. 3A to 3C are cross-sectional views illustrating a metallic foil of a semiconductor packaging structure and a method of fabricating the same according to a first embodiment of the present invention;
FIGs. 4A to 4L are cross-sectional views illustrating the semiconductor packaging structure and the method of fabricating the same according to the first embodiment of the present invention;
FIGs. 5A to 5C are cross-sectional views illustrating a metallic foil of a semiconductor packaging structure and a method of fabricating the same according to a second embodiment of the present invention;
FIGs. 6A to 6I are cross-sectional views illustrating the semiconductor packaging structure and the method of fabricating the same according to the second embodiment of the present invention.

### DETAILED DESCRIPTION OF PREFERRED EMBODIMENTS

It is to be understood that both the foregoing general descriptions and the detailed embodiments are exemplary and are, together with the accompanying drawings, intended to provide further explanation of technical features and advantages of the invention.

The following illustrative embodiments are provided to illustrate the disclosure of the present invention, these and other advantages and effects can be apparent to those skilled in the art after reading the disclosure of this specification.

### First embodiment

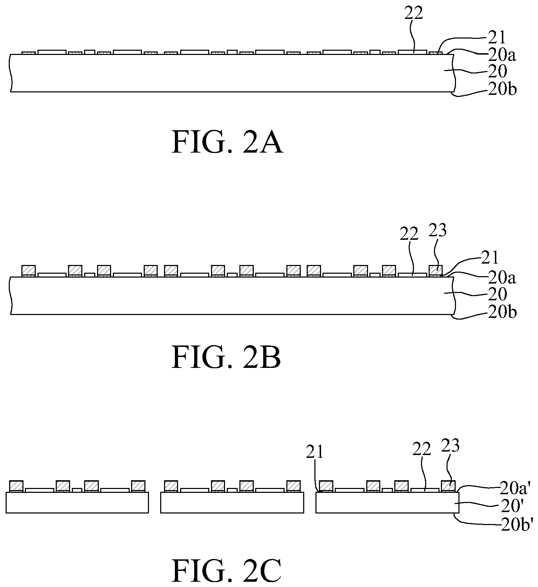

The implementation of the present invention can be divided into three stages. First, a plurality of semiconductor chips such as DRAMs are manufactured. Referring to FIGs. 2A to 2C, cross-sectional views illustrating semiconductor chips of a semiconductor packaging structure and a method of fabricating the same according to the present invention are provided.

As shown in FIG. 2A, a semiconductor wafer 20 has an active surface 20a and an inactive surface 20b opposing the active surface 20a, and a plurality of electrode pads 21 and a buffer layer 22 are formed on the active surface 20a.

As shown in FIG. 2B, a plurality of metal bumps 23 are formed on the electrode pads 21.

As shown in FIG. 2C, the semiconductor wafer 20 is thinned from the inactive surface 20b thereof, and is then cut to obtain a plurality of semiconductor chips 20'. The semiconductor chip 20' has an active surface 20a' and an inactive surface 20b' opposing the active surface 20', and a plurality of electrode pads 21 and a buffer layer 22 formed on the active surface 20a',. The metal bumps 23 are formed on the electrode pads 21.

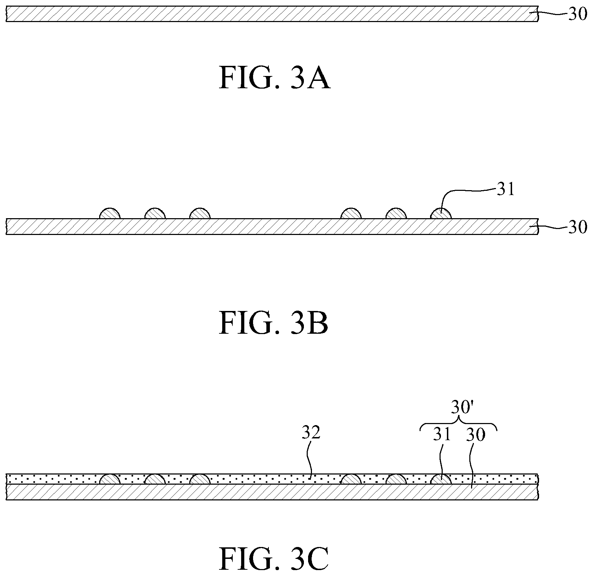

Second, a metallic foil 30' is manufactured. Referring to FIGs. 3A to 3C, cross-sectional views illustrating a metallic foil of a semiconductor packaging structure and a method of fabricating the same according to a first embodiment of the present invention are provided.

As shown in FIG. 3A, a metal plate 30 is provided. The metal plate 30 may be made of copper or other metals.

As shown in FIG. 3B, a plurality of printed bumps 31 are formed on the metal plate 30. The printed bumps 31 are made of silver, copper or aluminum. The printed bumps 31 may be cured depending on the circumstances.

As shown in FIG. 3C, a third adhesive layer 32 covering the printed bumps 31 is formed on the metal plate 30. The third adhesive layer 32 may be processed by a B-stage curing depending on the circumstances.

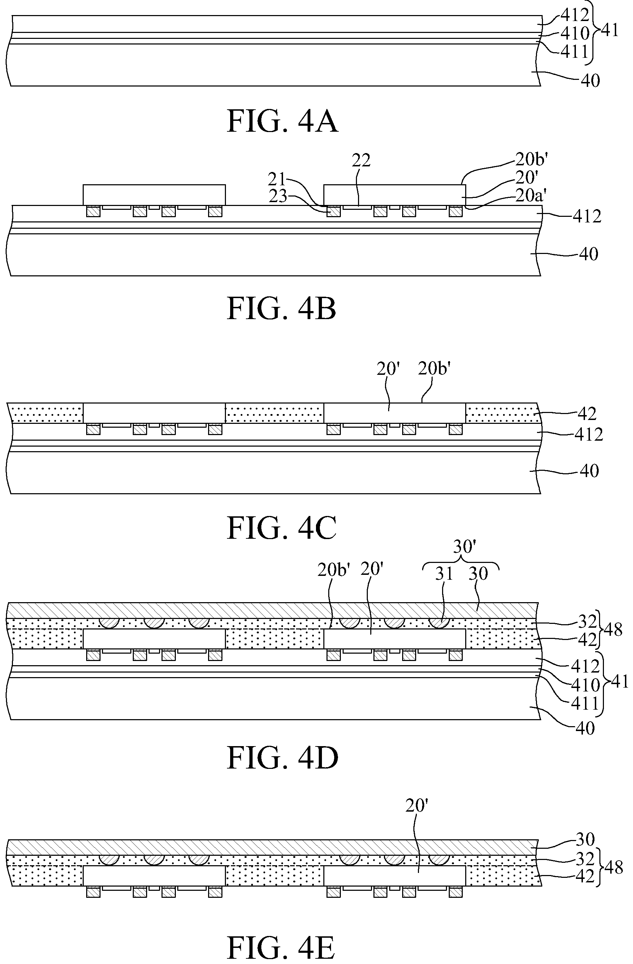

Finally, the assembling and packaging operations are implemented. Referring to FIGs. 4A to 4L, cross-sectional views illustrating the semiconductor packaging structure and the method of fabricating the same according to the first embodiment of the present invention are provided.

As shown in FIG. 4A, a fourth adhesive layer 411, a plastic film 410 and a first adhesive layer 412 are formed on one side of a carrier board 40. The fourth adhesive layer 411, the first plastic film 410 and the adhesive layer 412 are together to form a double-sided adhesive layer 41, and the double-sided adhesive layer 41 is attached to the carrier board 40.

As shown in FIG. 4B, the semiconductor chip 20' shown in FIG. 2C is attached to the first adhesive layer 412 via the metal bumps 23.

As shown in FIG. 4C, a second adhesive layer 42 is formed on the first adhesive layer 412, and the inactive surface 20b of the semiconductor chip 20' is exposed from the second adhesive layer 42.

As shown in FIG. 4D, the metallic foil 30' shown in FIG. 3C is attached to the second adhesive layer 42via the third adhesive layer 32, and each of the printed bumps 31 penetrates the third adhesive layer 32 to connect to the inactive surface 20b' of each of the semiconductor chips 20'. The second adhesive layer 42 and third adhesive layer 32 together form the packaging layer 48. The second adhesive layer 42 and the third adhesive layer 32 may be made of the same or different materials. The printed bumps 31 may be not in contact with the inactive surface 20b'. The printed bumps 31 are separated from the inactive surface 20b' by around 50 to 300 microns and can still achieve the purpose of heat dissipation via the printed bumps 31. In another embodiment, the third adhesive layer 32 is not formed on the metallic foil 30', and the metallic foil 30' is directly attached to the semiconductor chip 20' by the second adhesive layer 42.

As shown in FIG. 4E, the carrier board 40 and the double-sided adhesive layer 41 are removed.

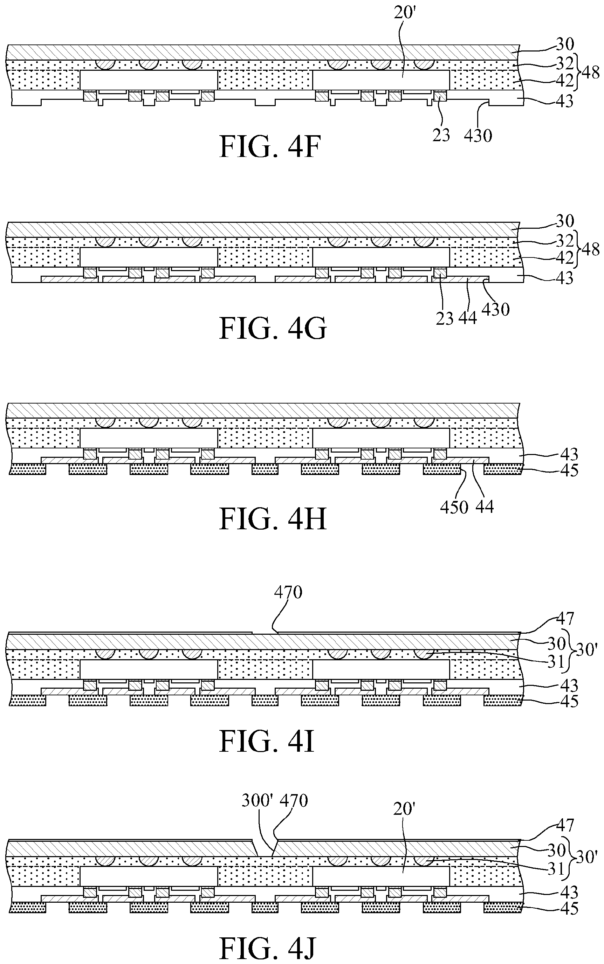

As shown in FIG. 4F, a dielectric layer 43 is formed on the second adhesive layer 42 and the semiconductor chip 20'. The dielectric layer 43 has a plurality of wiring pattern openings 430 for the metal bumps 23 to be exposed therefrom. The dielectric layer 43 may be made of Ajinomoto Build-up Film (ABF), polyimide or other materials, and the wiring pattern openings 430 are formed by excimer laser.

As shown in FIG. 4G, a wiring layer 44 electrically connected to the metal bumps 23 is formed in the wiring pattern openings 430. The wiring layer 44 may be made of copper.

As shown in FIG. 4H, an insulating protective layer 45 is formed on the dielectric layer 43 and the wiring layer 44. The insulating protective layer 45 has a plurality of insulating protective layer openings 450 to exposes a portion of the wiring layer 44.

As shown in FIG. 4I, a cover layer 47 having a plurality of cover layer grooves 470 is formed on the metallic foil 30'. A portion of the metallic foil 30' is exposed from the cover layer grooves 470. The cover layer 47 may be made of an insulation material or metal such as nickel.

As shown in FIG. 4J, the metallic foil 30' exposed from the cover layer grooves 470 is removed to form a plurality of metallic foil grooves 300'. Thus, the metallic foils 30' on the semiconductor chips 20' do not connect to each other.

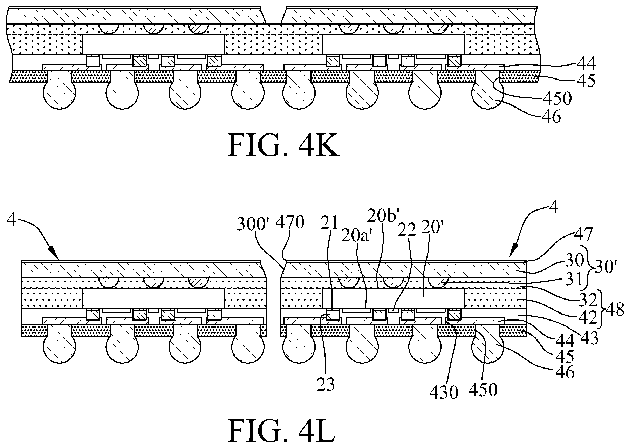

As shown in FIG. 4K, solder balls 46 are formed on the wiring layer 44 in each of the insulating protective layer openings 450.

As shown in FIG. 4L, the second adhesive layer 42, the third adhesive layer 32, the dielectric layer 43 and the insulating protective layer 45 are cut along the metallic foil grooves 300', to form a plurality of semiconductor packaging structures 4.

### Second embodiment

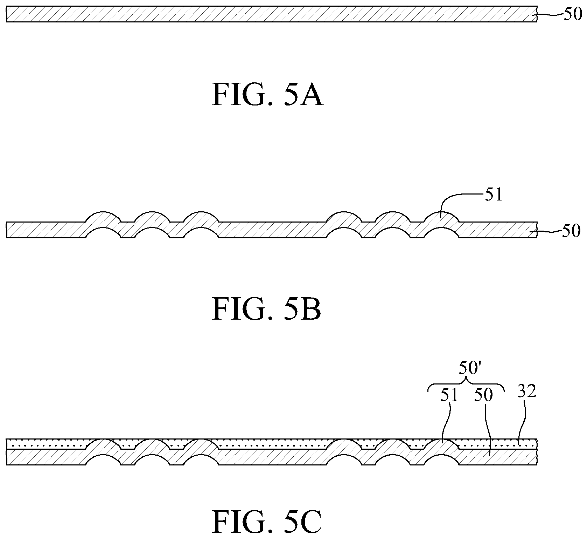

The primary difference between the first and second embodiments is the formation of the metallic foil. Referring to FIGs. 5A to 5C, cross-sectional views illustrating a metallic foil of a semiconductor packaging structure and a method of fabricating the same according to a second embodiment of the present invention are provided.

As shown in FIG. 5A, a metal plate 50 is provided. The metal plate 50 may be made of copper.

As shown in FIG. 5B, a plurality of punched bumps 51 are formed by punched the metal plate 50.

As shown in FIG. 5C, a third adhesive layer 32 covering the punched bumps 51 is formed on the metal plate 50. The third adhesive layer 32 may be processed by a B-stage curing depending on the circumstances.

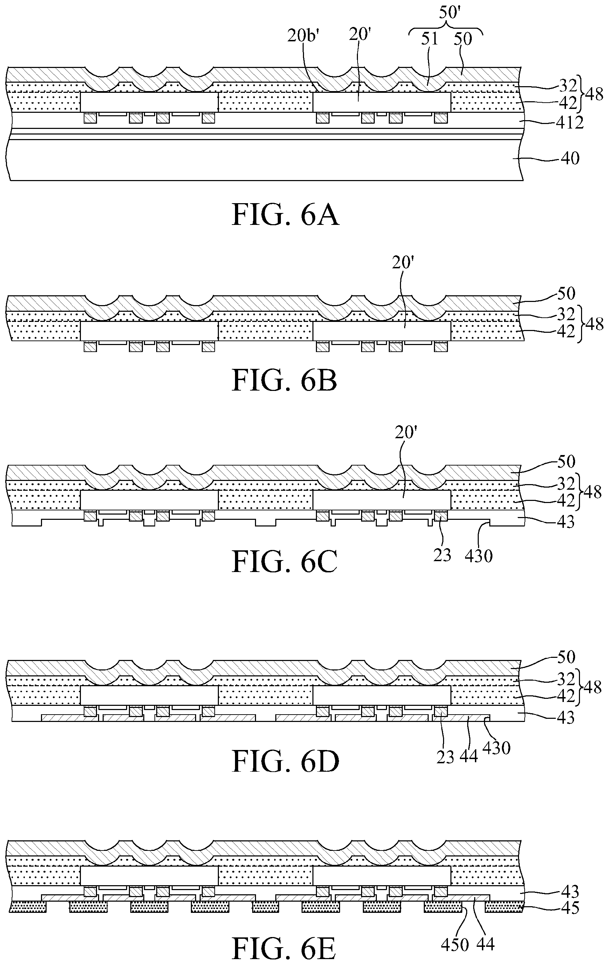

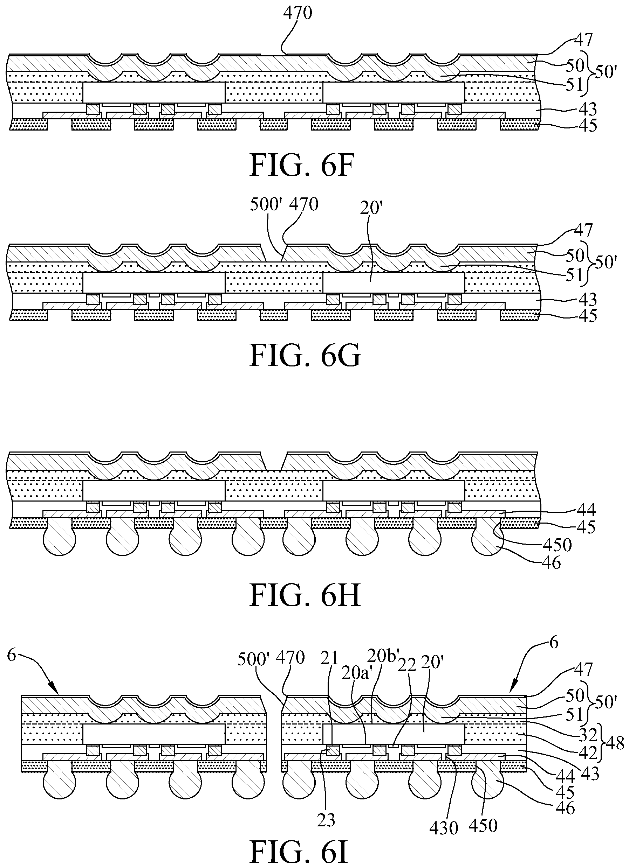

The assembling and packaging operations are then implemented. Referring to FIGs. 6A to 6I, cross-sectional views illustrating the semiconductor packaging structure 6 and the method of fabricating the same according to the second embodiment of the present invention are provided. Continuing from FIG. 4C, FIGs. 6A to 6I are approximately the same with FIGs. 4D to 4L. The primary difference is that the metallic foil 50' shown in FIG. 5C is substituted with metal foil 30'.

The present invention further provides the semiconductor packaging structure, comprising the semiconductor chips 20' having the active surface 20a' on which the electrode pads 21 formed and the inactive surface 20b' opposing the active surface 20a', and the metal bumps 23 formed on the electrode pads 21; the packaging layer 48 for encapsulating the semiconductor chips 20' and exposing the active surface 20a'; the dielectric layer 43 formed on the active surface 20a' and the surface of the packaging layer 48 at the same side with the active surface 20a' and having the wiring pattern openings 430 for the metal bumps 23 to be exposed therefrom; the wiring layer 44 formed in the wiring pattern openings 430 and electrically connected to the metal bumps 23, the wiring layer 44 extending to the dielectric layer 43 on the surface of the packaging layer 48 formed at the same side with the active surface 20a'; the insulating protective layer 45 formed on the dielectric layer 43 and the wiring layer 44, and having the openings 450 of the insulating protective layer to expose a portion of the wiring layer 44; and the metallic foil 30', 50' formed on the surface of the packaging layer 48 at the same side with the inactive surface 20b', the plurality of metallic protrusions such as the printed bumps 31 or the punched bumps 51 formed on the metallic foil 30' and penetrating the packaging layer 48 to connect to the inactive surfaces 20b' of the semiconductor chips 20', such that heat generated by the semiconductor chip 20' is dissipated to an ambient environment via the metallic protrusions.

The semiconductor packaging structure further comprises the cover layer 47 formed on the top surface of the metallic foil 30'. The cover layer 47 is made of an insulating material or metal.

The semiconductor packaging structure further comprises solder balls 46 formed on the wiring layer 44 in the opening 450 of the insulating protective layer.

The semiconductor packaging structure further comprises the buffer layer 22 formed on the active surface 20a'.

Compared to the prior art, the present invention employs the dielectric layer in the semiconductor packaging structure such that the gold wires of the prior art as the electrical conduction path and the packaging substrate as a chip carrier are not required, and thus the final overall thickness of the packaging structure is reduced effectively. Furthermore, as the present invention has the inactive surfaces of the semiconductor chips connected with the metallic protrusions, such as the printed bumps or the punched bumps, heat generated by the semiconductor chip can be directly transferred to the metallic foil that has large area for heat dissipation. Finally, the present invention requires no gold wires to transmit electrical signals, such that better electrical transmission efficiency can be achieved, and the reliability of the final product can be enhanced, while saving the material costs for the gold.

## Claims

1. A semiconductor packaging structure, comprising:
a semiconductor chip (20') having an active surface (20a') and an opposing inactive surface (20b');
a plurality of electrode pads (21) disposed on the active surface;
a plurality of metal bumps (23) disposed on the electrode pads;
a packaging layer (48) encapsulating the semiconductor chip with the active surface of the semiconductor chip exposed therefrom;
a dielectric layer (43) formed on the active surface and a surface of the packaging layer at the same side with the active surface and having a plurality of wiring pattern opening areas (430) for the metal bumps to be exposed therefrom;
a wiring layer (44) formed in the wiring pattern opening areas and electrically connected to the metal bumps, wherein the wiring layer extends to the dielectric layer on the surface of the packaging layer formed at the same side with the active surface;
an insulating protective (45) formed on the dielectric layer and the wiring layer, and having a plurality of openings (450) for a portion of the wiring layer to be exposed therefrom;
a metallic foil (30') formed on the surface of the packaging layer at the same side with the inactive surface; and
a plurality of metallic protrusions (31, 51) formed on the metallic foil and penetrating the packaging layer to be in contact with the inactive surface of the semiconductor chip, so as to dissipate heat generated by the semiconductor chip to an ambient environment,
wherein the metallic protrusions are printed bumps or punched bumps, and wherein for the punched bumps, dimples are formed on an exposed surface of the metallic foil and conform with the metallic protrusions.

2. The semiconductor packaging structure of claim 1, further comprising a cover layer formed on a top surface of the metallic foil.

3. The semiconductor packaging structure of claim 2, wherein the cover layer is made of an insulating material or a metal material.

4. The semiconductor packaging structure of claim 1, further comprising a plurality of solder balls disposed on the wiring layer formed in the openings of the insulating protective layer.

5. The semiconductor packaging structure of claim 1, further comprising a buffer layer formed on the active surface.

6. A method of fabricating the semiconductor packaging structure according to claim 1, the method comprising:
mounting a plurality of semiconductor (20') on a first adhesive layer (412) formed on a carrier board (40), wherein each of the semiconductor chips has an active surface (20a') and an inactive surface (20b') opposing the active surface, and a plurality of metal bumps (23) are formed on a plurality of electrode pads (21) formed on the active surface, such that the semiconductor chips are mounted on the first adhesive layer via the metal bumps;
forming a second adhesive layer (42) on the first adhesive layer, while exposing the inactive surfaces of the semiconductor chips from the second adhesive layer;
providing a metallic foil (30') having a third adhesive layer (32) formed on the metallic foil, wherein the metallic foil has a plurality of metallic protrusions exposed from the third adhesive layer;
attaching the metallic foil to the second adhesive layer via the third adhesive layer, wherein the metallic protrusions are in contact with the inactive surface of each of the semiconductor chips exposed from the second adhesive layer;
removing the carrier board and the first adhesive layer;
forming a dielectric layer (43) on the second adhesive layer (42) and the semiconductor chips, wherein the dielectric layer is formed with a plurality of wiring pattern openings (430) for exposing the metal bumps;
forming a wiring layer (44) in each of the wiring pattern openings for the wiring layer to be electrically connected to the metal bumps;
forming an insulating protective layer (45) on the dielectric layer and the wiring layer, wherein the insulating protective layer has a plurality of insulating protective layer openings (450) for a portion of the wiring layer to be exposed therefrom;
removing a portion of the metallic foil to form a plurality of metallic foil grooves (470), such that the metallic foil on each of the semiconductor chips is free from connection with each other; and
cutting the second adhesive layer, the third adhesive layer, the dielectric layer and the insulating protective layer along the metallic foil grooves, so as to form a plurality of semiconductor packaging structures.

7. The method of claim 6, wherein the metallic foil grooves are formed by:
forming a cover layer having a plurality of cover layer grooves on the metallic foil; and
removing the metallic foil exposed in the cover layer grooves.

8. The method of claim 7, wherein the cover layer is made of an insulating material or a metal material.

9. The method of claim 6, further comprising forming a plurality of solder balls on the wiring layer in the insulating protective layer openings, prior to cutting the second adhesive layer.

10. The method of claim 6, further comprising disposing a plastic film and a fourth adhesive layer between the first adhesive layer and the carrier board, wherein the plastic film is formed between the first adhesive layer and the fourth adhesive layer, the fourth adhesive layer is formed between the plastic film and the carrier board, and the removal of the first adhesive layer includes removing the plastic film and the fourth adhesive layer.

11. The method of claim 6, wherein the metallic foil and the third adhesive layer are formed by:
forming a plurality of printed bumps on a metal plate; and
forming the third adhesive layer covering the printed bumps on the metal plate.

12. The method of claim 11, further comprising curing the printed bumps after forming the printed bumps.

13. The method of claim 6, wherein the metallic foil and the third adhesive layer are formed by:
forming a plurality of punched bumps on a metal plate; and
forming the third adhesive layer covering the punched bumps on the metal plate.

14. The method of claim 13, further comprising curing the third adhesive layer after forming the third adhesive layer.

## Patentansprüche

1. Halbleiter-Baueinheits-Struktur, umfassend:
einen Halbleiterchip (20'), der eine aktive Fläche (20a'), und eine gegenüberliegende inaktive Fläche (20b') aufweist;
eine Vielzahl an Elektrodenpads (21), die auf der aktiven Fläche angeordnet sind;
eine Vielzahl an Metallbumps (23),
die auf den Elektrodenpads angeordnet sind;
eine Verpackungsschicht (48),
die den Halbleiterchip mit der aktiven Fläche des Halbleiterchips einkapselt, der davon freiliegt;
eine dielektrische Schicht (43),
die auf der aktiven Fläche und einer Fläche der Verpackungsschicht
auf der gleichen Seite mit der aktiven Fläche ausgebildet ist und eine Vielzahl an Verdrahtungsmuster-Öffnungsbereichen (430) aufweist, sodass die Metallbumps davon freiliegen;
eine Verdrahtungsschicht (44),
die in den Verdrahtungsmuster-Öffnungsbereichen ausgebildet ist und mit den Metallbumps elektrisch verbunden ist, wobei die Verdrahtungsschicht sich zu der dielektrischen Schicht auf der Fläche der Verpackungsschicht erstreckt, die auf der gleichen Seite wie die aktive Fläche ausgebildet ist;
ein isolierender Schutz (45),
der auf der dielektrischen Schicht und der Verdrahtungsschicht ausgebildet ist,
und eine Vielzahl an Öffnungen (450) aufweist,
sodass ein Abschnitt der Verdrahtungsschicht davon freiliegt,
um davon frei zu liegen;
eine metallische Folie (30'),
die auf der Fläche der Verpackungsschicht auf der gleichen Seite mit der inaktiven Schicht ausgebildet ist; und
eine Vielzahl an metallischen Vorsprüngen (31, 51),
die auf der metallischen Folie ausgebildet sind und in die Verpackungsschicht eindringen, um mit der inaktiven Fläche des Halbleiterchips in Kontakt zu sein,
um Wärme, die durch den Halbleiterchip erzeugt wurde, an eine Außenumgebung abzugeben,
wobei die metallischen Vorsprünge gedruckte Bumps oder gestanzte Bumps sind, und wobei für die gestanzten Bumps, Vertiefungen auf einer freigelegten Fläche der metallischen Folie ausgebildet sind und den metallischen Vorsprüngen entsprechen.

2. Halbleiter-Baueinheits-Struktur gemäß Anspruch 1, weiterhin umfassend, eine Abdeckungsschicht, die auf einer Oberfläche der metallischen Folie ausgebildet ist.

3. Halbleiter-Baueinheits-Struktur gemäß Anspruch 2, wobei die Abdeckungsschicht aus einem isolierenden Material oder einem Metallmaterial ist.

4. Halbleiter-Baueinheits-Struktur gemäß Anspruch 1, die weiterhin eine Vielzahl an Lötkugeln umfasst, die auf der Verdrahtungsschicht angeordnet sind, die in den Öffnungen der isolierenden Schutzschicht ausgebildet ist.

5. Halbleiter-Baueinheits-Struktur gemäß Anspruch 1, die weiterhin eine Pufferschicht umfasst, die auf der aktiven Fläche ausgebildet ist.

6. Verfahren zur Herstellung der Halbleiter-Baueinheits-Struktur gemäß Anspruch 1, wobei das Verfahren umfasst:
Befestigen einer Vielzahl an Halbleitern (20') auf einer ersten Haftschicht (412), die auf einer Trägerplatte (40) ausgebildet ist,
wobei jeder der Halbleiterchips eine aktive Fläche (20a') und eine inaktive Fläche (20b')aufweist, die der aktiven Fläche gegenüberliegt, und eine Vielzahl an Metallbumps (23) auf einer Vielzahl von Elektrodenpads (21) ausgebildet sind,
die auf einer aktiven Fläche ausgebildet sind, sodass
die Halbleiterchips auf der ersten Haftschicht über den Metallbumps befestigt sind;
Ausbilden einer zweiten Haftschicht (42)
auf der ersten Haftschicht, während die inaktiven Flächen des Halbleiterchips von der zweiten Haftschicht freigelegt werden;
Bereitstellen einer metallischen Folie (30'), die eine dritte Haftschicht (32) aufweist,
die auf der metallischen Folie ausgebildet ist,
wobei die metallische Folie eine Vielzahl an metallischen Vorsprüngen aufweist, die von der dritten Haftschicht freiliegen;
Anbringen der metallischen Folie an die zweite Haftschicht über die dritte Haftschicht, wobei die metallischen Vorsprünge mit der inaktiven Fläche von jedem der Halbleiterchips in Kontakt stehen, die von der zweiten Haftschicht freiliegen;
Entfernen der Trägerplatte und der ersten Haftschicht;
Ausbilden einer dielektrischen Schicht (43) auf der zweiten Haftschicht (42) und den Halbleiterchips, wobei die dielektrische Schicht mit einer Vielzahl an Verdrahtungsmuster-Öffnungen (430) ausgebildet ist, um die Metallbumps frei zu legen;
Ausbilden einer Verdrahtungsschicht (44) in jeder der Verdrahtungsmuster-Öffnungen, damit die Verdrahtungsschicht elektrisch mit den Metallbumps verbunden ist;
Ausbilden einer isolierenden Schutzschicht (45) auf der dielektrischen Schicht und der Verdrahtungsschicht,
wobei die isolierende Schutzschicht eine Vielzahl an isolierenden Schutzschicht Öffnungen (450) aufweist,
so dass ein Abschnitt der Verdrahtungsschicht davon freiliegt;
Entfernen eines Abschnitts der metallischen Folie, um eine Vielzahl an metallischen Folienrillen (470) auszubilden, sodass die metallische Folie auf jedem der Halbleiterchips frei von der Verbindung miteinander ist; und
Schneiden der zweiten Haftschicht, der dritten Haftschicht, der dielektrischen Schicht und der isolierenden Schutzschicht entlang den metallischen Folienrillen, um so eine Vielzahl an Halbleiter-Baueinheits-Strukturen auszubilden.

7. Verfahren gemäß Anspruch 6, wobei die metallischen Folienrillen ausgebildet werden durch:
Ausbilden eine Abdeckungsschicht mit einer Vielzahl an Abdeckungsschichtrillen auf der metallischen Folie; und
Entfernen der metallischen Folie, die in den Abdeckungsschichtrillen freiliegen.

8. Verfahren gemäß Anspruch 7, wobei die Abdeckungsschicht aus einem isolierenden Material oder einem Metallmaterial hergestellt ist.

9. Verfahren gemäß Anspruch 6, weiterhin umfassend, Ausbilden einer Vielzahl an Lötkugeln auf der Verdrahtungsschicht in den isolierenden Schutzschicht Öffnungen, vor dem Schneiden der zweiten Haftschicht.

10. Verfahren gemäß Anspruch6, weiterhin umfassend, Anordnen eines Plastikfilms und einer vierten Haftschicht zwischen der ersten Haftschicht und der Trägerplatte, wobei der Plastikfilm zwischen der ersten Haftschicht und der vierten Haftschicht ausgebildet ist, wobei die vierte Haftschicht zwischen dem Plastikfilm und der Trägerplatte ausgebildet ist, und wobei das Entfernen der ersten Haftschicht Entfernen des Plastikfilms und der vierten Haftschicht beinhaltet.

11. Verfahren gemäß Anspruch 6, wobei die metallische Folie und die dritte Haftschicht ausgebildet werden durch:
Ausbilden einer Vielzahl an gedruckten Bumps auf einer Metallplatte ; und
Ausbilden der dritten Haftschicht, die die gedruckten Bumps auf der Metallplatte abdeckt.

12. Verfahren gemäß Anspruch 11, weiterhin umfassend, Aushärten der gedruckten Bumps, nachdem die gedruckten Bumps ausgebildet wurden.

13. Verfahren gemäß Anspruch 6, wobei die metallische Folie und die dritte Haftschicht ausgebildet werden durch:
Ausbilden einer Vielzahl an gestanzten Bumps auf einer Metallplatte; und
Ausbilden der dritten Haftschicht, die die gestanzten Bumps auf der Metallplatte abdeckt.

14. Verfahren gemäß Anspruch 13, weiterhin umfassend, Aushärten der dritten Haftschicht, nachdem die dritte Haftschicht ausgebildet wurde.

## Revendications

1. Structure de conditionnement de semi-conducteur, comprenant :
une puce de semi-conducteur (20') ayant une surface active (20a') et une surface inactive (20b') opposée ;
une pluralité de pastilles d'électrode (21) disposées sur la surface active ;
une pluralité de bossages métalliques (23) disposés sur les pastilles d'électrode ;
une couche de conditionnement (48) encapsulant la puce de semi-conducteur avec la surface active de la puce de semi-conducteur exposée depuis celle-ci ;
une couche de diélectrique (43) formée sur la surface active et une surface de couche de conditionnement sur le même côté avec la surface active et ayant une pluralité de zones d'ouverture de schéma d'interconnexion (430) pour que les bossages métalliques soient exposés depuis celles-ci ;
une couche d'interconnexion (44) formée dans les zones d'ouverture de schéma d'interconnexion et raccordée électriquement aux bossages métalliques, dans lequel la couche d'interconnexion s'étend vers la couche diélectrique sur la surface de la couche de conditionnement formée sur le même côté avec la surface active ;
une couche protectrice isolante (45) formée sur la couche de diélectrique et la couche d'interconnexion et ayant une pluralité d'ouvertures (450) pour qu'une partie de la couche d'interconnexion soit exposée depuis celle-ci ;
un film métallique (30') formé sur la surface de la couche de conditionnement sur le même côté avec la surface inactive ; et
une pluralité de saillies métalliques (31, 51) formée sur le film métallique et pénétrant la couche de conditionnement destinée à être en contact avec la surface inactive de la puce de semi-conducteur de façon à dissiper la chaleur générée par la puce de semi-conducteur vers un environnement ambiant,
dans lequel les saillies métalliques sont des bossages imprimés ou des bossages poinçonnés, et dans laquelle pour les bossages poinçonnés, des alvéoles sont formées sur une surface exposée du film métallique et se conforment aux saillies métalliques.

2. Structure de conditionnement de semi-conducteur selon la revendication 1, comprenant en outre une couche de couverture formée sur une surface supérieure du film métallique.

3. Structure de conditionnement de semi-conducteur selon la revendication 2, dans laquelle la couche de couverture est faite d'un matériau isolant ou d'un matériau métallique.

4. Structure de conditionnement de semi-conducteur selon la revendication 1, comprenant en outre une pluralité de billes de brasage sur la couche d'interconnexion formée dans les ouvertures de la couche protectrice isolante.

5. Structure de conditionnement de semi-conducteur selon la revendication 1, comprenant en outre une couche tampon formée sur la surface active.

6. Procédé de fabrication d'une structure de conditionnement de semi-conducteur selon la revendication 1, le procédé comprenant :
de monter une pluralité de semi-conducteurs (20') sur une première couche adhésive (412) formée sur un circuit porteur (40),
dans lequel chacune des puces de semi-conducteur a une surface active (20a') et une surface inactive (20b') opposée à la surface active, et une pluralité de bossages métalliques (23) sont formés sur une pluralité de pastilles d'électrode (21) formées sur la surface active de telle façon que les puces de semi-conducteur soient montées sur la première couche adhésive par le biais des bossages métalliques ;
de former une deuxième couche adhésive (42) sur la première couche adhésive, tout en exposant les surfaces inactives des puces de semi-conducteur depuis la deuxième couche adhésive ;
de fournir un film métallique (30') ayant une troisième couche adhésive (32) formée sur le film métallique,
dans lequel le film métallique a une pluralité de saillies métalliques exposées depuis la troisième couche adhésive ;
de fixer le film métallique à la deuxième couche adhésive par le biais de la troisième couche adhésive, dans lequel les saillies métalliques sont en contact avec la surface inactive de chacune des puces de semi-conducteur exposées depuis la deuxième couche adhésive ;
de retirer le circuit porteur et la première couche adhésive ;
de former une couche de diélectrique (43) sur la deuxième couche adhésive (42) et les puces de semi-conducteur, dans lequel la couche de diélectrique est formée avec une pluralité de zones d'ouverture de schéma d'interconnexion (430) pour exposer les bossages métalliques ;
de former une couche d'interconnexion (44) dans chacune des ouvertures de schéma d'interconnexion pour que la couche d'interconnexion soit connectée électriquement aux bossages métalliques ;
de former une couche protectrice isolante (45) sur la couche de diélectrique et la couche d'interconnexion,
dans lequel la couche protectrice isolante a une pluralité d'ouvertures de couche protectrice isolante (450) pour qu'une partie de la couche d'interconnexion soit exposée depuis celle-ci ;
de retirer une partie du film métallique pour former une pluralité de rainures de film métallique (470) de façon à ce que les films métalliques sur chacune des puces de semi-conducteur soient exempts de connexion entre eux ; et
de couper la deuxième couche adhésive, la troisième couche adhésive, la couche de diélectrique et la couche protectrice isolante le long des rainures de film métallique de façon à former une pluralité de structures de conditionnement de semi-conducteur.

7. Procédé selon la revendication 6, dans lequel les rainures de film métallique sont formées par :
la formation d'une couche de couverture ayant une pluralité de rainures de couches de couverture sur le film métallique ; et
de retirer le film métallique exposé dans les rainures de couche de couverture.

8. Procédé selon la revendication 7, dans lequel la couche de couverture est faite d'un matériau isolant ou d'un matériau métallique.

9. Procédé selon la revendication 6, comprenant en outre de former une pluralité de billes de brasage sur la couche d'interconnexion dans les ouvertures de la couche protectrice isolante, avant de couper la deuxième couche adhésive.

10. Procédé selon la revendication 6, comprenant en outre de disposer un film plastique et une quatrième couche adhésive entre la première couche adhésive et le circuit porteur, dans lequel le film plastique est formé entre la première couche adhésive et la quatrième couche adhésive, la quatrième couche adhésive est formée entre le film plastique et le circuit porteur, et le retrait de la première couche adhésive inclut de retirer le film plastique et la quatrième couche adhésive.

11. Procédé selon la revendication 6, dans lequel le film métallique et la troisième couche adhésive sont formés par :
la formation d'une pluralité de bossages imprimés sur une plaque métallique ; et
la formation de la troisième couche adhésive couvrant les bossages imprimés sur la plaque métallique.

12. Procédé selon la revendication 11, comprenant en outre de durcir les bossages métalliques après avoir formé les bossages imprimés.

13. Procédé selon la revendication 6, dans lequel le film métallique et la troisième couche adhésive sont formés par :
la formation d'une pluralité de bossages poinçonnés sur une plaque métallique ; et
la formation de la troisième couche adhésive couvrant les bossages poinçonnés sur la plaque métallique.

14. Procédé selon la revendication 13, comprenant en outre de durcir la troisième couche adhésive après la formation de la troisième couche adhésive.
